# EUROPEAN PATENT APPLICATION

(11) **EP 4 727 272 A1**
(43) Date of publication of application: **15.04.2026**
(21) Application number: 24205956.6
(22) Date of filing: 10.10.2024
(51) Int. Cl.: H05K 5/02, H05K 5/15

(54) **CASING ASSEMBLY**

(71) Applicant: Delta Electronics (Thailand) Public Co., Ltd., Samutprakarn 10280 (TH)
(72) Inventor: Klotzbücher, Guenael, 79102 Freiburg (DE)
(74) Representative: Keller Schneider Patent- und Markenanwälte AG

(57) **Abstract**

The invention relates to a casing assembly comprising a first casing part (1) and a second casing part (2), with the first casing part (2) and the second casing part (2) being configured to together provide a casing after an assembly, with the first casing part (1) and the second casing part (2) being locked to one another after the assembly at least through a snap-fit connection and with the first casing part (1) and the second casing part (2) being in an undeformed state before the assembly. The first casing part (1) comprises 1) at least one springy arm (3, 4), wherein each springy arm of the at least one springy arm (3, 4, 21, 25) comprises a first end (5) and a second end (6), and 2) at least one protruding part (7, 8, 22, 26), with each protruding part of the at least one protruding part (7, 8, 22, 26) comprising a respective engagement portion (10) and with the at least one protruding part (7, 8, 22, 26) comprising at least one recess (9), wherein at least one protruding part (7, 8, 22, 26) of the at least one protruding part (7, 8, 22, 26) is arranged on each springy arm (3, 4, 21, 25) of the at least one springy arm (3, 4, 21, 25) and wherein the at least one protruding part (7, 8, 22, 26) arranged on the respective springy arm is arranged at the second end (6) of the respective springy arm (3, 4, 21, 25). The second casing part (2) comprises 1) at least one access channel (13, 18, 19), with each access channel (13, 18, 19) of the at least one access channel having a corresponding protruding part (7, 8, 22, 26) of the at least one protruding part and being configured for receiving the corresponding protruding part (7, 8, 22, 26), with the at least one access channel (13, 18, 19) being arranged such that during the assembly, the at least one corresponding protruding part (7, 8, 22, 26) of the first casing part (1) passes through the at least one access channel (13, 18, 19), and 2) at least one mating portion (14), with each mating portion of the at least one mating portion (14) having a corresponding recess (9) of the at least one recess, and with the at least one mating portion (14) being configured to provide, together with the at least one corresponding recess (9) of the first casing part (1), the snap-fit connection after the assembly. The first casing part (1) and the second casing part (2) are configured such that after the assembly, the first casing part (1) is in a deformed state, and the first casing part (1) and the second casing part (2) are configured such that after the assembly, the first casing part (1) is exerting a force on the at least one mating portion (14) of the second casing part (2).

## Description

### Technical field

The invention relates to a casing assembly comprising a first casing part and a second casing part.

### Background Art

Casings, in particular metal casings, for power supply unit are known in the prior art which are assembled using fasteners, in particular screws and rivets. Screws have the disadvantage that a precise positioning of parts is needed before connecting the parts with the screw, that additional tools are needed and that a minimal height is required. Rivets have the disadvantage that disassembly is destructive.

Other methods for assembling casings as known in the prior art involve unidirectional fastening techniques, in particular involving keyholes, hooks, slots, grooves, seams, etc. For these assembly techniques, disassembly is typically performed in the reverse direction as the assembly; further for these assembly techniques, typically additional fastening is required as these fastening techniques do not provide sufficient strength of connection and stability.

Further techniques for assembling casings as known in the prior art involve steps such as gluing, welding, forming, in particular clinching, etc., which lead to a destructive disassembly in case later disassembly of the assembled casing is needed. For these further techniques, further tools or additional components are needed and large forces may be involved, potentially causing damage during the assembly or during a disassembly.

In the prior art, spring clips are also known for unidirectional fastening. Such spring clips have the disadvantage that additional components, namely the spring clips, are required, that are typically also damaged during a disassembly.

### Summary of the invention

It is the object of the invention to create a casing assembly that mitigates at least some of the disadvantages of casing assemblies as known in the prior art.

The solution of the invention is specified by the features of claim 1. The invention relates to a casing assembly comprising a first casing part and a second casing part, with the first casing part and the second casing part being configured to together provide a casing after an assembly, with the first casing part and the second casing part being locked to one another after the assembly at least through a snap-fit connection and with the first casing part and the second casing part being in an undeformed state before the assembly. The first casing part comprises 1) at least one springy arm, wherein each springy arm of the at least one springy arm comprises a first end and a second end, 2) at least one protruding part, with each protruding part of the at least one protruding part comprising a respective engagement portion and with the at least one protruding part comprising at least one recess, wherein at least one protruding part of the at least one protruding part is arranged on each springy arm of the at least one springy arm and wherein the at least one protruding part arranged on the respective springy arm is arranged at the second end of the respective springy arm. The second casing part comprises 1) at least one access channel, with each access channel of the at least one access channel having a corresponding protruding part of the at least one protruding part and being configured for receiving the corresponding protruding part, with the at least one access channel being arranged such that during the assembly, the at least one corresponding protruding part of the first casing part passes through the at least one access channel, and 2) at least one mating portion, with each mating portion of the at least one mating portion having a corresponding recess of the at least one recess, and with the at least one mating portion being configured to provide, together with the at least one corresponding recess of the first casing part, the snap-fit connection after the assembly. The first casing part and the second casing part are configured such that after the assembly, the first casing part is in a deformed state, and the first casing part and the second casing part are configured such that after the assembly, the first casing part is exerting a force on the at least one mating portion of the second casing part.

Advantageously, the casing assembly according to the invention may be used for assembling a casing without further tools, with the locking between the first casing part and the second casing part being provided at least through a snap-fit connection. The casing assembly may be suited for a power supply unit, for example. The casing may therefore be assembled from only the first casing part and the second casing part, and no additional parts may be required for assembling the casing. The first casing part and the second casing part may be designed such that the assembled casing fully surrounds an interior space.

The first casing part and the second casing part are designed such that, when assembled into the casing, the first casing part is deformed, with the deformation leading to restoration forces in the first casing part. After the assembly, the snap-fit connection between the first casing part and the second casing part is such that the first casing part and the second casing part are substantially stationary with respect to one another; through the restoration forces, the first casing part is pushed against the second casing part, in turn leading to a tighter contact between the first casing part and the second casing part. Preferentially, the first casing part and the second casing part are designed such that the deformation experienced by the first casing part during the assembly is reversible, i.e. the assembled casing may be assembled and disassembled a plurality of times.

Before the assembly, the first casing part is in an undeformed state, and after the assembly, the first casing part is in a deformed state. The first casing part comprises at least one springy arm, with each springy arm of the at least one springy arm having a first end and a second end, respectively. Each springy arm is preferentially such that a deformation within an elastic deformation region from an equilibrium shape of the springy arm causes elastic restoration forces in the springy arm that act to restore the shape of the springy arm to its equilibrium shape. To assemble the casing from the first casing part and the second casing part, after a suitable initial relative placement of the first casing part with respect to the second casing part, the casing assembly may be assembled by deforming the first casing part through an application of a deformation force on the second end(s) of the at least one springy arm.

The first casing part may comprise one springy arm, or the first casing part may comprise two springy arms, or the first casing part may comprise more than two springy arms. The second casing part is adapted to the number of springy arms of the first casing part. Each springy arm of the at least one springy arm comprises at least one protruding part of the at least one protruding part.

In case the first casing part comprises one springy arm, the at least one protruding part is arranged at the second end of the springy arm; to lock respectively fasten the springy arm to the second casing part, the springy arm may comprise a first part of a fastening portion and the second casing part may comprise a second part of the fastening portion, with the first part of the fastening portion being arranged at the first end of the springy arm, and the first part and the second part of the fastening portion together enabling a fastening of the springy arm at its first end to the second casing part. Through the at least one protruding part arranged at the second end of the springy arm and the at least one mating portion of the second casing part, the second end of the springy arm may be snap-fitted to the second casing part.

The first casing part may also comprise an extension portion which may be connected to the first end of the one springy arm. In this case, the first portion of the fastening portion may be arranged at a distal end of the extension portion with respect to the first end of the springy arm, while the at least one protruding part is still arranged at the second end of the one springy arm. In case the assembled casing substantially corresponds to a rectangular cuboid, in the assembled casing the extension portion and the springy arm may each form one surface of the rectangular cuboid, while the remaining surfaces of the rectangular cuboid may be provided by the second casing part.

The fastening portion may be embodied in manners known from the prior art, preferably implementing fastening techniques that do not require dedicated tools for carrying out the fastening, for example involving hooks or slots. The needed structural modifications for providing the fastening portion may be provided in the first casing part or in the second casing part or in both the first casing part and the second casing part.

In case the first casing part comprises two springy arms, the two first ends of the two springy arms may be connected to one another through a connecting section, and the two second ends may be considered as free ends. In this case, at the two second ends of the two springy arms, in total at least two protruding parts may be arranged, with each springy arm comprising at least one protruding part of the at least two protruding parts.

Through the interaction of the protruding parts with the second casing part as described further below, the first casing part and the second casing part may be both tightly connected to one another as well as locked through a snap-fit connection; the interaction of the protruding parts with the second casing part may be initiated by applying a force to the second ends of the springy arms. Each protruding part has an engagement portion, which engagement portion may be at a distal end of the protruding part with respect to the second end of the springy arm to which it is attached. The first casing part and the second casing part are preferentially designed such that during the assembly, the engagement portions of the protruding parts come first - compared to the remaining section of the protruding parts - into contact with the second casing part.

The snap-fit connection after the assembly is specifically provided through the interaction between at least one recess in the at least one protruding part and at least one mating portion of the second casing part. Preferentially, each recess of the at least one recess may be embodied as a cut-out, and each mating portion of the at least one mating portion as bulging-out obstruction, which bulging-out obstruction may fit into the recess corresponding to the bulging-out obstruction and thereby provide the snap-fit connection. A height of the at least one bulging-out obstruction may be designed by taking into account the deformability of the protruding parts. Dimensions of cut-out(s) and bulging-out obstruction(s) may vary across the first casing part and the second casing part, with corresponding cut-out(s) and bulging-out obstruction(s) necessarily being matched to each other, or dimensions may be uniform, i.e. all cut-out(s) and bulging-out obstruction(s) may be embodied similarly. In case the first casing part comprises two springy arms, for example, the first casing part may comprise at least two recesses, with the at least two recesses being distributed such that the protruding parts of both springy arms comprise each at least one recess.

The second casing part comprises at least one access channel. The at least one access channel is preferentially positioned such in the second casing part that for each springy arm of the at least one springy arm, at least one protruding part arranged on the respective springy arm passes through a corresponding access channel of the at least one access channel during the assembly. Each access channel is preferentially formed through two, in particular parallel, surfaces that - with respect to an assembly/disassembly direction along which the protruding part corresponding to the access channel is configured to be moved during the assembly/a later disassembly - are displaced, i.e. that at least partly, preferentially fully, do not face each other. In a direction orthogonal to the assembly/disassembly direction, the two surfaces may be distanced from one another by such a distance that when the corresponding protruding part is in contact with both surfaces, movement of the protruding part is substantially only possible along the assembly/disassembly direction. Accordingly, each access channel may thereby constrain movement freedom during the assembly and after the assembly of the corresponding protruding part and thereby of the springy arm on which the corresponding protruding part is arranged. Advantageously, the access channels may therefore be made flat and have a small space usage within the assembled casing; thereby, more storage space within the assembled casing may be provided.

Preferentially, the first casing part and the second casing part are designed such that during the assembly, the protruding part corresponding to an access channel is changing its orientation with respect to the assembly direction, which change of orientation causes the remainder of the first casing part to be pulled towards the second casing part: through the interaction between the access channels and the corresponding protruding parts during the assembly, the first casing part and the second casing part may therefore advantageously be brought into tight contact as the geometry of the first casing part and of the second casing part may induce forces during the assembly that cause a tight contact. To enable a better initial contact angle between a protruding part and an access channel, the engagement portion of the protruding part may be inclined with respect to a remainder of the protruding part.

The protruding part corresponding to an access channel may therefore during the assembly initially only be in contact with one of the two surfaces that correspond to the access channel and only later during the assembly be in contact with both surfaces that correspond to the access channel.

A protruding part corresponding to an access channel may also correspond to a mating portion: such a protruding part may also comprise a recess, in particular embodied as a cut-out. A first casing part of the inventive casing assembly therefore may require at a minimum one protruding part, which one protruding part may have a recess and which one protruding part may be configured to first pass through an access channel before interacting with a mating portion. Similarly, a second casing part of the inventive casing assembly may require at a minimum one access channel and one mating portion. Accordingly, in such an embodiment the mating portion corresponding to the protruding part may be arranged behind the access channel with respect to the assembly direction, with such an embodiment providing for both a tight connection between the first casing part and the second casing part and for a locking through the snap-fit connection provided through the recess and the mating portion.

In case of two springy arms, the first casing part may require at a minimum two protruding parts, with each springy arm of the two springy arms comprising one of the two protruding parts and each of the two protruding parts having a respective recess. Similarly in this case, the second casing part may require at a minimum two access channels and two mating portions, with the two mating portions being arranged behind the access channels in the assembly direction. The minimum number of protruding parts, access channels and mating portions proceeds similarly for more than two springy arms, i.e. with an increasing number of springy arms, the minimum number of protruding parts, recesses, access channels and mating portions increases: for N springy arms, N being a natural number greater or equal than '1', at a minimum N protruding parts, N recesses, N access channels and N mating portions are required.

The first casing part and the second casing part may also be designed such that some protruding parts are only associated to access channels and not to mating portions and therefore do not comprise recesses, while other protruding parts are only associated to mating portions and not to access channels and are therefore not guided through an access channel during the assembly. The first casing part and the second casing part of a casing assembly according to the invention provide both (i) a pull function for tightly pulling the first casing part and the second casing part to each other during/after the assembly through the interaction of the first casing part with the access channels and (ii) a locking function through the snap-fit connection.

In case of two springy arms, for example, in the undeformed state before the assembly, the two second ends may be separated from one another by an undeformed distance, while in the deformed state after the assembly the two second ends may be separated from one another by a deformed distance which is smaller than the undeformed distance. Accordingly, during the assembly the second ends of the two springy arms may be pushed closer together.

The first casing part and the second casing part preferentially may be designed such that the casing may be assembled in two steps. In a first step, the first casing part is moved into an initial position with respect to the second casing part; in the first step, no deformation forces may act on the first casing part. In case of one springy arm, for example, in the first step the first casing part may be fastened to the second casing part using the fastening portion previously described. The initial position may be such that in a subsequent second step for assembling the casing, in the case of two springy arms, for example, the two second ends may only need to be pushed together, while in the case of one springy arm, a force may need to be applied to the second end of the springy arm to push the at least one protruding part arranged at the second end towards the at least one access channel and the at least one mating portion. Preferentially, after the first step and before the second step, the engagement portions of the protruding parts are close to the second casing part so that the assembly may be reliably executed without accidently deforming the first casing part in such a way that the access channels and/or mating portions are missed by the protruding parts. To minimise spatial requirements, in the undeformed state all protruding parts arranged on a common springy arm may be substantially coplanar, i.e. arranged in a common plane. In case of two springy arms, for example, the protruding parts which may be arranged on a first springy arm of the two springy arms may be substantially coplanar, i.e. arranged in a first common plane, and the protruding parts arranged on the second springy arm of the two springy arms may be substantially coplanar as well, i.e. arranged in a second common plane.

In an embodiment of the casing assembly according to the invention, the exerted force is an elastic restoration force.

In a further embodiment of the casing assembly according to the invention, each of the at least one recess is embodied as a cut-out, and each of the at least one mating portion is embodied as a bulging-out obstruction, and the first casing part and the second casing part are such that after the assembly, each bulging-out obstruction is arranged in the corresponding cut-out.

In a further embodiment of the casing assembly according to the invention, the first casing part and the second casing part are configured such that a shape of the at least one protruding part is substantially the same in both the undeformed state and in the deformed state of the first casing part.

During the assembly, those protruding parts that correspond to access channels may be deformed while passing through the access channels, while those protruding parts that correspond to mating portions may be deformed while passing over the bulging-out obstructions. Once a protruding part has passed through the access channel and/or over the bulging-out obstruction, the deformation of the protruding part may be undone by restoration forces arising in the protruding part in the wake of the deformation.

In a further embodiment of the casing assembly according to the invention, the first casing part is embodied in one piece and/or the second casing part is embodied in one piece.

Advantageously, the first casing part and/or the second casing part may therefore be made in a simplified manner. The first casing part may, however, also be assembled from separate components. Similarly, the second casing part may also be assembled from separate components.

In a further embodiment of the casing assembly according to the invention, the first casing part and/or the second casing part are made of a metal, in particular aluminium or steel. Preferentially, the first casing part may be made of stainless steel while the second casing part may be made of aluminium. Besides aluminium or steel, other metals or other materials may be used as well.

Using a metal for the first casing part and/or the second casing part advantageously may provide electromagnetic shielding functionality and stability to the assembled casing.

In a further embodiment of the casing assembly according to the invention, the first casing part is made of a metal sheet and/or the second casing part is made of a metal sheet.

By using metal sheets as a base for producing the first casing part and/or the second casing part, the first casing part and/or the second casing part may advantageously be produced using techniques such as bending, cutting, etc., which allow a large degree of automation in production. The second casing part may also be manufactured through different techniques, for example through die casting. Metals sheets advantageously enable in particular a thin and flexible first casing part.

In a further embodiment of the casing assembly according to the invention, the metal sheet which the first casing part is made of has a thickness between 0.2 mm and 3 mm, in particular between 0.4 mm and 1.2 mm, preferentially equal to 0.8 mm, and/or the metal sheet which the second casing part is made of has a thickness of between 0.5 mm and 5 mm, in particular between 1 mm and 3 mm, preferentially equal to 1.5 mm.

In case the first casing part is made of stainless steel and has a thickness between 0.4 mm and 1.2 mm, the at least one springy arm of the first casing part may advantageously be bent without requiring a too large force to be applied while still providing sufficient stability. In case the first casing part is made of aluminium and has a thickness between 0.8 mm and 2.4 mm, the at least one springy arm of the first casing part may advantageously be bent as well without requiring too large forces. The casing may hence advantageously be assembled manually without needing further tools. In general, the first casing part and the second casing part should not be too thin to preserve stability, while in particular the first casing part should also not be too thick so that the at least one springy arm may be deformed without too large forces being required. Suitable thickness ranges of the first casing part and of the second casing part therefore also depend on the chosen material and on the dimensions of the assembled casing. In case the assembled casing correspond to a substantially rectangular cuboid, the rectangular cuboid may have dimensions of approximately 100 mm x 100 mm x 100 mm, for example.

In a further embodiment of the casing assembly according to the invention, in the undeformed state, the at least one springy arm is curved, and after the assembly in the deformed state, the at least one springy arm is substantially planar.

In case of two springy arms that are curved in the undeformed state, the two second ends of the springy arms may be suitably distanced from one another, while at the same time providing advantageous restoration forces in the deformed state, for example. Preferentially in this case, the two springy arms may be curved in such a manner that the curvature may be removed during the assembly by simply pushing the second ends of the springy arms towards each other. Similarly in case of one springy arm, the first casing part and the second casing part may be designed such that after the assembly, the springy arm is substantially planar, in particular forming one surface of the six surfaces of a rectangular cuboid.

In a further embodiment of the casing assembly according to the invention, in both the undeformed state before the assembly and in the deformed state after the assembly, each of the at least one protruding part is oriented in a substantially orthogonal manner to the second end of the respective springy arm on which it is arranged.

When the first casing part is placed into the initial position with respect to the second casing part, the at least one protruding part may be oriented in such a way that it is directed towards the second casing part. In case of one springy arm, by then pushing the springy arm at its second end towards the second casing part, the at least one protruding part may be pushed towards the second casing part. In case of two springy arms, by then pushing the two springy arms together at their second ends, the protruding parts are pushed towards the second casing part. In case all protruding parts arranged on a springy arm are substantially coplanar with respect to one another and lie in a common plane, orthogonality may be measured between the respective common plane and the second end of the respective springy arm.

In a further embodiment of the casing assembly according to the invention, the second casing part comprises at least one disassembly cut-out, with the at least one disassembly cut-out being positioned such that each protruding part of the at least one protruding part that is snap-fitted with a corresponding mating portion after the assembly is accessible from an outside and may be pushed away from the at least one disassembly cut-out, and with each disassembly cut-out in particular having a corresponding mating portion of the at least one mating portion and being positioned in a vicinity of the corresponding mating portion.

The disassembly cut-outs may preferentially be shaped in such a way that an access through the disassembly cut-outs from outside by accident is reduced. Advantageously, to disassemble the assembled casing, a deliberate access through the disassembly cut-outs may be needed, in particular through a dedicated tool if the disassembly cut-outs are suitably shaped; a disassembly of the assembled casing through forces acting on the outside of the casing may advantageously be prevented. By pushing the protruding parts that are in a snap-fit connection sufficiently far away from the second casing part, the snap-fit connection may be lifted and the first casing part separated from the second casing part, in particular through action of the restoration forces.

In a further embodiment of the casing assembly according to the invention, the first casing part and the second casing part are such that after the assembly, each protruding part corresponding to an access channel is on at least two opposite sides at least partially and in particular tightly in contact with the second casing part.

In a further embodiment of the casing assembly according to the invention, the first casing part comprises at least one bearing surface, which at least one bearing surface is positioned such that after the assembly, the second casing part is in contact with the at least one bearing surface.

Through the at least one bearing surface, possible movements between the first casing part and the second casing part are advantageously further reduced in the assembled casing.

In a further embodiment of the casing assembly according to the invention, the first casing part comprises one springy arm, with the at least one protruding part being arranged at the second end of the springy arm, wherein the first casing part comprises a first part of a fastening portion arranged at the first end of the springy arm, wherein the second casing part comprises a second part of the fastening portion, and wherein the first part and the second part of the fastening portion are configured to fasten the first end of the springy arm to the second casing part after the assembly.

In a further embodiment of the casing assembly according to the invention, the assembled casing fully surrounds an interior space, and the assembled casing substantially corresponds to a rectangular cuboid, and after the assembly, one surface of the rectangular cuboid is provided by the first casing part and five connected surfaces of the rectangular cuboid are provided by the second casing part.

In a further embodiment of the casing assembly according to the invention, the first casing part comprises one springy arm and an extension portion connected to the first end of the springy arm, with the at least one protruding part being arranged at the second end of the springy arm, wherein the first casing part comprises a first part of a fastening portion arranged at a distal end of the extension portion with respect to the first end of the springy arm, wherein the second casing part comprises a second part of the fastening portion, wherein the first part and the second part of the fastening portion are configured to fasten the distal end of the extension portion to the second casing part after the assembly, and wherein after the assembly, the assembled casing fully surrounds an interior space and the assembled casing substantially corresponds to a rectangular cuboid, with four connected surfaces of the rectangular cuboid being provided by the second casing part and two connected surfaces of the rectangular cuboid being provided by the springy arm and the extension portion.

In a further embodiment of the casing assembly according to the invention, 1) the first casing part comprises two springy arms and at least two protruding parts, with the at least two protruding parts comprising at least two recesses, wherein at least one first protruding part of the at least two protruding parts is arranged at the second end of a first springy arm of the two springy arms and wherein at least one second protruding part of the at least two protruding parts is arranged at the second end of a second springy arm of the two springy arms, with the at least one first protruding part comprising at least one first recess of the at least two recesses and with the at least one second protruding part comprising at least one second recess of the at least two recesses, and wherein the first casing part comprises a connecting section connecting the two springy arms between their respective first ends, and 2) the second casing part comprises at least two access channels and at least two mating portions, with each access channel of the at least two access channels having a corresponding protruding part of the at least two protruding parts and being configured for receiving the corresponding protruding part, with the at least two access channels being arranged such that during the assembly, the corresponding protruding parts of the first casing part pass through the at least two access channels, and with each mating portion of the at least two mating portions having a corresponding recess of the at least two recesses, and with the at least two mating portions being configured to provide, together with the corresponding recesses of the first casing part, the snap-fit connection after the assembly. In this embodiment, in the undeformed state of the first casing part, the two second ends are separated from one another by an undeformed distance, and in the deformed state of the first casing part, the two second ends are separated from one another by a deformed distance, which deformed distance is smaller than the undeformed distance, and the first casing part and the second casing part are configured such that after the assembly, the first casing part is exerting a force on the at least two mating portions of the second casing part.

In a further embodiment of the casing assembly according to the invention, the assembled casing fully surrounds an interior space, wherein the assembled casing substantially corresponds to a rectangular cuboid, and wherein after the assembly, three connected surfaces of the rectangular cuboid are provided by the first casing part and three connected surfaces of the rectangular cuboid are provided by the second casing part.

The second casing part may therefore comprise three substantially planar surfaces, with any two connected planar surfaces of the three planar surfaces having a right angle between them. After the assembly, the deformed first casing part may therefore also comprise three substantially planar surfaces having a right angle between them.

In a further embodiment of the casing assembly according to the invention, the first casing part and the second casing part are configured such that the first casing part is symmetric with respect to a first plane of symmetry both in the undeformed state and in the deformed state, which first plane of symmetry intersects the first casing part only in the connecting section, and the second casing part is symmetric with respect to a second plane of symmetry, which second plane of symmetry is such that after the assembly, the first plane of symmetry and the second plane of symmetry coincide, and the force exerted by the first casing part on the second casing part after the assembly is substantially orthogonal to the coinciding first and second planes of symmetry.

Advantageously, a symmetric layout of both the first casing part and the second casing part may lead to a balanced distribution of forces in the assembled casing.

In a further embodiment of the casing assembly according to the invention, the first casing part comprises exactly two protruding parts, with the at least one first protruding part comprising one protruding part of the exactly two protruding parts and with the at least one second protruding part comprising another protruding part of the exactly two protruding parts, and the at least one first recess comprises exactly one first recess and the least one second recess comprises exactly one second recess, and the second casing part comprises exactly two access channels and exactly two mating portions.

In a further embodiment of the casing assembly according to the invention, the first casing part and the second casing part are configured such that during the assembly, the two engagement portions pass first through the two access channels before coming into contact with the mating portions.

Other advantageous embodiments and combinations of features come out from the detailed description below and the entirety of the claims.

### Brief description of the drawings

The drawings used to explain the embodiments show:
Fig. 1 shows an embodiment of a first casing part and of a second casing part;
Fig. 2 shows an embodiment of the first casing part and of the second casing part of Fig. 1 during an assembly and after the assembly;
Fig. 3 shows another embodiment of a first casing part and of a second casing part during an assembly;
Fig. 4 shows a further embodiment of a first casing part and of a second casing part both before and after an assembly; and
Fig. 5 shows a further embodiment of a first casing part and of a second casing part both before and after an assembly.

In the figures, the same components are given the same reference signs.

### Preferred embodiments

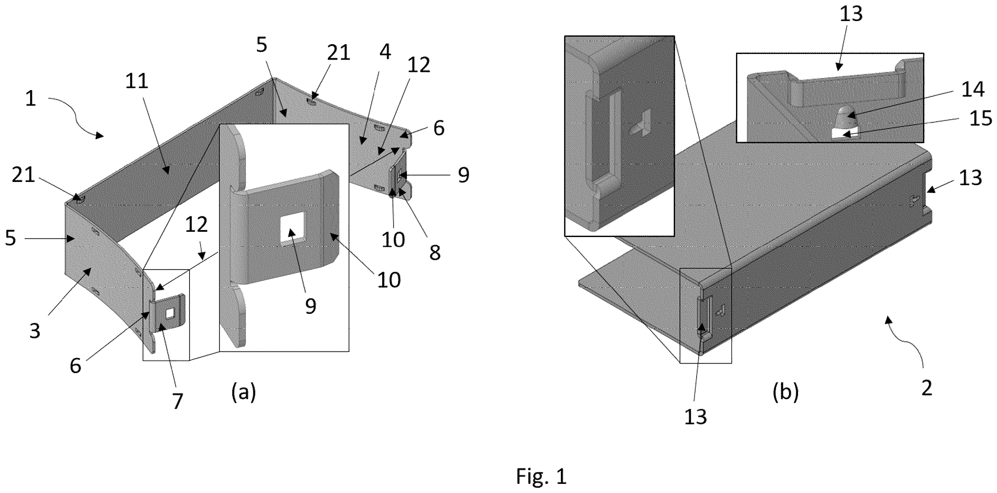

**Fig. 1** shows an embodiment of a first casing part 1 in Fig. 1a and of a second casing part 2 in Fig. 1b for assembling a casing. The first casing part 1 comprises a first springy arm 3 and a second springy arm 4, wherein both the first springy arm 3 and the second springy arm 4 are curved. At a respective first end 5 of both the first springy arm 3 and the second springy arm 4, the two springy arms 3, 4 are connected through a connecting section 11; between the first end 5 of the first springy arm 3 and the connecting section 11, a substantially right angle is formed, and between the first end 5 of the second springy arm 4 and the connecting section 11, a substantially right angle is formed as well.

In Fig. 1a, the first casing part 1 is shown in an undeformed state. When deforming the first casing part 1 away from the undeformed state, restoration forces arise in the first casing part 1 that act to restore the first casing part 1 to its shape in the undeformed state. In this undeformed state, the two springy arms 3, 4 are curved in such a way that an undeformed distance 12 between second ends 6 of the first springy arm 3 and the second springy arm 4 is larger than a similarly oriented undeformed distance between the first ends 5 of the first springy arm 3 and the second springy arm 4.

At the second end 6 of the first springy arm 3, a first protruding part 7 is arranged, and at the second end 6 of the second springy arm 4, a second protruding part 8 is arranged. In the undeformed state as shown in Fig. 1a, both the first protruding part 7 and the second protruding part 8 are arranged such on the first springy arm 3 respectively the second springy arm 4 that a substantially right angle is formed between the respective second ends 6 of the springy arms 3, 4 and the protruding parts 7, 8. Each of the two protruding parts 5, 8 comprises a central cut-out 9 as well as an engagement portion 10, which engagement portion 10 may be at a suitable angle with respect to the remainder of the respective protruding part 7, 8.

The first casing part 1 of Fig. 1a may be formed in one piece from a metal sheet through well-known processing techniques, in particular involving bending and cutting. Through suitable choices of (i) the used metal, (ii) a thickness of the metal sheet and (iii) the curvature of the springy arms 3, 4, the forces needed to deform the first casing part 1 to its shape in a deformed state in which it is part of the assembled casing may be precisely controlled.

The second casing part 2 shown in Fig. 1 b comprises three connected surfaces, with any two connected surfaces having a substantially right angle between them. The first casing part 1 of Fig. 1a and the second casing part 2 of Fig. 1b are designed such that a casing assembled from these two casing parts 1, 2 corresponds to a rectangular cuboid.

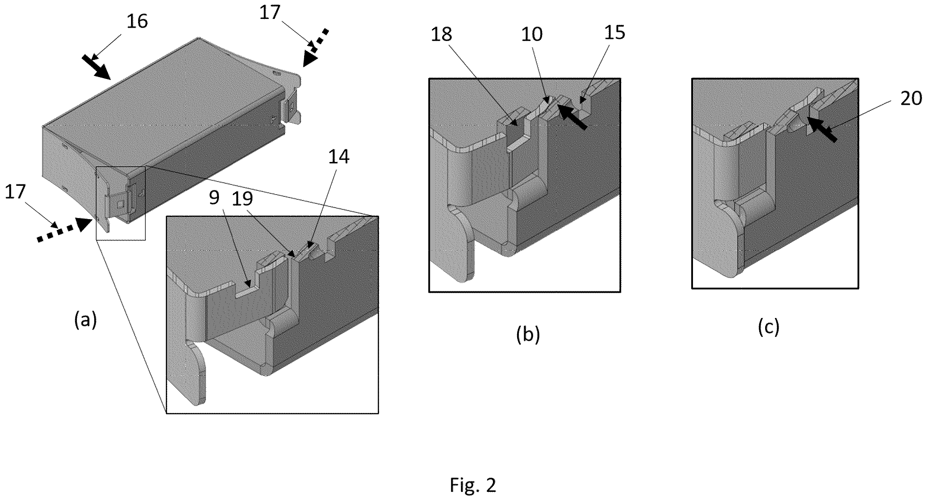

The second casing part 2 comprises two access channels 13, two mating portions 14 embodied as bulging-out obstructions and two disassembly cut-outs 15. The access channels 13 are formed in such a manner in the second casing part 2 that, during the assembly of the casing, the protruding parts 7, 8 of the first casing part 1 are moved through the access channels 13, with each protruding part 7, 8 being moved through one access channel of the two access channels 13. The precise layout of the access channels 13 is described further below in more detail with respect to Fig. 2. After having passed through the access channel 13, the protruding parts 7, 8 engage with the mating portions and finally provide a snap-fit connection through an interaction between their cut-outs 9 and the mating portions 14, specifically the bulging-out obstructions. As described further below with respect to Fig. 2, by applying a suitable force through the two disassembly cut-outs 15, an assembled casing may be disassembled.

**Fig. 2** shows an embodiment of the first casing part 1 and of the second casing part 2 of Fig. 1 during an assembly in Fig. 2a and Fig. 2b and after the assembly in Fig. 2c. The assembly substantially comprises two steps 16, 17. In a first step 16, the first casing part 1 is brought into an initial position with respect to the second casing part 2. In this initial position, the first casing part 1 and the second casing part 2 already form a substantially rectangular cuboid, with the main deviation from the rectangular cuboid being the two springy arms 3, 4 which are still bent away. In a second step 17, a force is applied to the second ends 6 of the two springy arms 3, 4, pushing the second ends 6 of the two springy arms 3, 4 towards each other.

Both the first casing part 1 and the second casing part 2 are designed such that when in the initial position, the engagement portions 10 of the two protruding parts 7, 8 are close to the access channels 13 to facilitate assembly. After the first step 16 is completed, the first casing part 1 is still in its undeformed state. The distance between the engagement portions 10 of the two protruding parts 7, 8, which engagement portions 10 are the parts of the first casing part 1 that are closest to the access channels 13 in the initial position, in the undeformed state is preferentially slightly larger than a distance between the access channels 13.

When pushing the second ends 6 of the springy arms 3, 4 towards one another in the second step 17, the engagement portions 10 first come into contact with the respective access channel 13. As shown in Fig. 2a and Fig. 2b, each access channel 13 may be provided through two surfaces 18, 19 that are displaced with respect to one another in an assembly direction along which the protruding parts 7, 8 substantially move during the assembly. The two surfaces 18, 19 are further distanced from one another to such an extent that as visible in Fig. 2b and Fig. 2c, the protruding parts 7, 8 may be in tight contact with both the surfaces 18, 19 during and after the assembly. Accordingly, the two surfaces 18, 19 limit movement freedom during and after the assembly. During the assembly, the engagement portion 10 of each protruding part 7, 8 first comes into contact with one 18 surface of the two surfaces 18, 19 that form the access channel 13, before coming into contact with the other 19 surface of the two surfaces 18, 19.

The access channels 13 are such that during the assembly, the protruding parts 7, 8 are deformed, thereby pulling the first casing part 1 towards the second casing part 2 and providing a tight fit between the first casing part 1 and the second casing part 2. After having passed through the access channels 13, each engagement portion 10 is deformed by the respective bulging-out obstruction 14 as visible in Fig. 2b and indicated by the black arrow in Fig. 2b. Having passed the two bulging-out obstructions 14, a snap-fit connection is provided as the two bulging-out obstructions are arranged in the two recesses 9 of the protruding parts 7, 8 as visible in Fig. 2c. As indicated in Fig. 2c, disassembly is possible by pushing 20 the protruding parts 7, 8 away from the second casing part 2, the pushing 20 being possible through two disassembly cut-outs 15 in the second casing part 2.

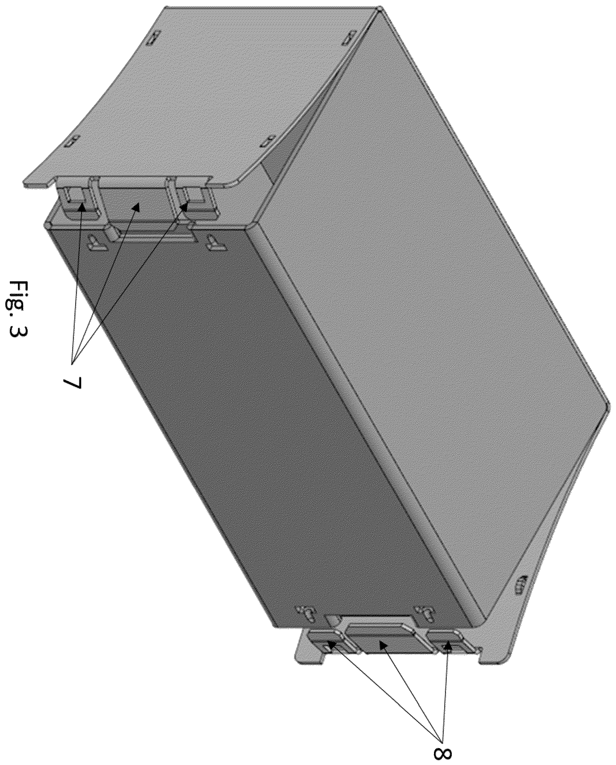

**Fig. 3** shows another embodiment of a first casing part and of a second casing part during an assembly. The first casing part of the embodiment of Fig. 3 differs from the first casing part 1 of the embodiments of Fig. 1 and Fig. 2 in that the first casing part comprises three first protruding parts 7 and three second protruding parts 8. In the embodiment of Fig. 3, the two outer first protruding parts 7 and the two outer second protruding parts 8 each comprise a cut-out, while the central first protruding part 7 and the central second protruding part 8 does not comprise a cut-out. All six protruding parts 7, 8 comprise respective engagement portions.

The second casing part of Fig. 3 comprises two access channels that are dimensioned such as to receive the central protruding parts 7, 8 of the first casing part. In terms of internal structure, the access channels of Fig. 3 correspond to the access channels 13 of Fig. 2. The second casing part of Fig. 3 further comprises four mating portions, in particular bulging-out obstructions. Each of the four bulging-out obstructions is configured to provide a snap-fit connection together with a corresponding cut-out of the four cut-outs of the two outer first protruding parts 7 and the two outer second protruding parts 8.

Using the two access channels and the two central protruding parts 7, 8 of the embodiment of Fig. 3, the first casing part is thereby tightly pulled towards the second casing part while at the same time being put into a snap-fit connection through interaction between the four recesses and the four bulging-out obstructions.

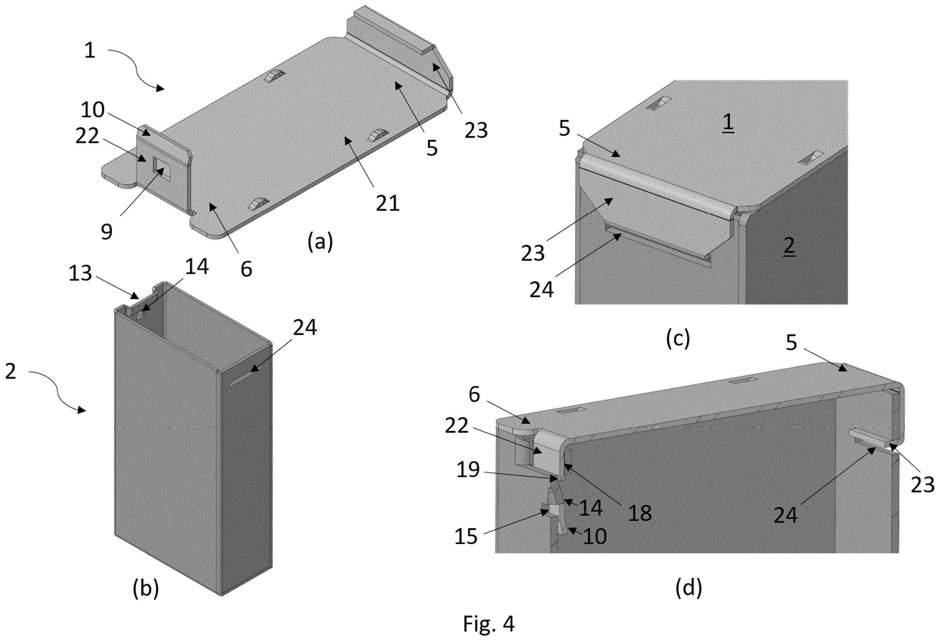

**Fig. 4** shows a further embodiment of a first casing part 1 and of a second casing part 2 both before and after an assembly. Fig. 4a shows the first casing part 1 before the assembly, with the first casing part 1 comprising one springy arm 21 with a first end 5 and a second end 6. The springy arm 21 of Fig. 4a is substantially planar; at the first end 5 of the springy arm 21, a first part 23 of a fastening portion is arranged, which first part 23 of the fastening portion is configured to interact with a second part 24 of the fastening portion arranged on the second casing part 2 shown in Fig. 4b. The first part 23 of the fastening portion comprises a hook, which hook is arranged on a flat section that is connected to the springy arm 21, and the second part 24 of the fastening portion comprises a slot, with the hook being arranged to pass through the slot.

At the second end 6 of the springy arm 21, a protruding part 22 is arranged with an engagement portion 10 and a recess 9 embodied as a cut-out. The protruding part 22 is configured to interact with an access channel 13 and a mating portion 14 of the second casing part 2. Protruding part 22, access channel 13 and mating portion 14 are embodied as described with respect to Figs. 1 to 3. The first part 23 of the fastening portion, the second part 24 of the fastening portion and the springy arm 21 are configured such that after the assembly, the first casing part 1 is exerting a force on the mating portion 14 of the second casing part 2 through the protruding part 22. In the embodiment of Fig. 4, the first part 23 of the fastening portion is such that before and after the assembly, the first part 23 is oriented differently with respect to the springy arm 21, the changed orientation being such that the protruding part 22 is exerting a force on the mating portion 14 after the assembly. More specifically, the first part 23 of the fastening portion, specifically the flat section thereof, is connected at a bending line to the springy arm 21 at which bending line the first part 23 of the fastening portion may be bent relatively to the springy arm 21. Through suitable design of an angle between the flat section of the first part 23 and the springy arm 21 in an equilibrium shape of the first casing part 1 before the assembly, the first casing part 1 may be designed such that after the assembly -through restoration forces arising in the first casing part 1 to restore its equilibrium shape -, the first casing part 1 is firmly connected to the second casing part 2.

Alternatively or in addition to the previously described mechanism, the first casing part 1 may also be designed with a curved springy arm and optionally a first part of the fastening portion whose flat section is arranged in a substantially orthogonal manner to the springy arm. This way, restoration forces that push the protruding part against the mating portion after the assembly may also arise from the deformation of the springy arm after the assembly.

Fig. 4c shows a close view of the assembled casing assembly close to the first end 5 of the first casing part 1. As visible in Fig. 4c, the hook of the first part 23 of the fastening portion is arranged in the slot of the second part 24 of the fastening portion. Fig. 4d shows a sectional view through the casing assembly after the assembly. The access channel of Fig. 4d is as described above with respect to Figs. 1 to 3, i.e. the access channel comprises two opposite sides 18, 19. In Fig. 4d, the disassembly cut-out 15 is visible as well. After the assembly of the embodiment of Fig. 4, five sides of the resulting rectangular cuboid are provided by the second casing part 2 and one side of the resulting rectangular cuboid is provided by the first casing part 1.

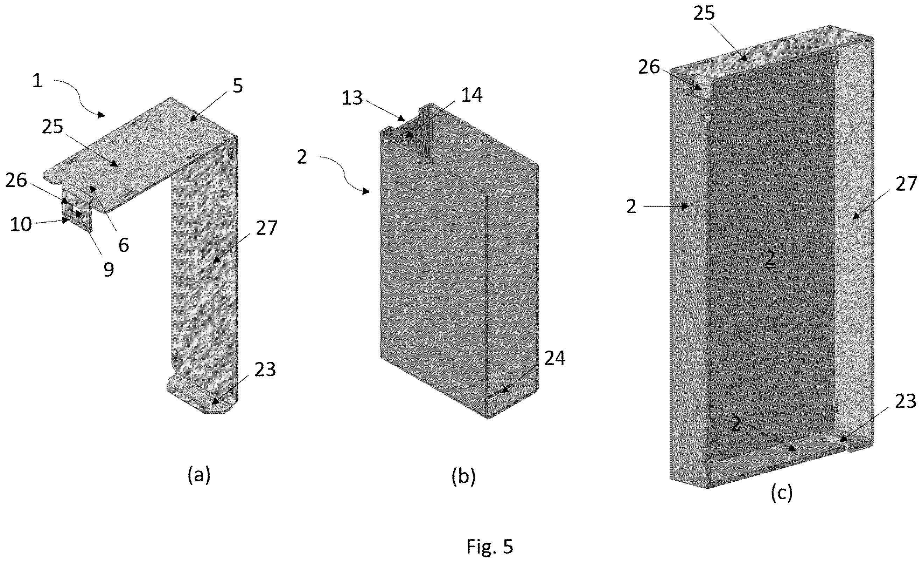

**Fig. 5** shows a further embodiment of a first casing part 1 and of a second casing part 2 both before and after an assembly, with Fig. 5a and Fig. 5b showing the first casing part 1 respectively the second casing part 2 before assembly and Fig. 5c sectional view through the casing assembly after an assembly. The embodiment of Fig. 5 is similar to the embodiment of Fig. 4, the main difference being that the first part 23 of the fastening portion is not arranged on the springy arm 25 but at a distal end of an extension portion 27 with respect to the springy arm 25, with the extension portion 27 being arranged at a first end 5 of the springy arm 25 and with a protruding part 26 being arranged at a second end 6 of the springy arm 25. The protruding part 26 and a corresponding access channel 13 in the second casing part 2 are embodied as previously described with respect to Figs. 1 to 4.

Through a suitable design of an angle between the springy arm 25 and the extension portion 27 in an equilibrium shape of the first casing part 1 before the assembly, after the assembly the first casing part 1 may exert a force on the second casing part 2 and the first part 23 of the fastening portion may exert a force on the second part 24 of the fastening portion as well. To enable such restoration forces, in the embodiment of Fig. 5, the angle between the springy arm 25 and the extension portion 27 may for example be made slightly larger than 90 degrees in an equilibrium shape before the assembly. Alternatively or in addition, the springy arm 25 and/or the extension portion 27 may also be formed in a curved manner in the equilibrium shape as described with respect to Figs. 1 to 4.

After the assembly of the casing assembly, four sides of the resulting rectangular cuboid are provided by the second casing part 2 and two sides of the resulting rectangular cuboid are provided by the first casing part 1.

## Claims

1. Casing assembly comprising a first casing part (1) and a second casing part (2), with the first casing part (2) and the second casing part (2) being configured to together provide a casing after an assembly, with the first casing part (1) and the second casing part (2) being locked to one another after the assembly at least through a snap-fit connection and with the first casing part (1) and the second casing part (2) being in an undeformed state before the assembly, wherein the first casing part (1) comprises
• at least one springy arm (3, 4, 21, 25), wherein each springy arm of the at least one springy arm (3, 4, 21, 25) comprises a first end (5) and a second end (6), and
• at least one protruding part (7, 8, 22, 26), with each protruding part of the at least one protruding part (7, 8, 22, 26) comprising a respective engagement portion (10) and with the at least one protruding part (7, 8, 22, 26) comprising at least one recess (9), wherein at least one protruding part (7, 8, 22, 26) of the at least one protruding part (7, 8, 22, 26) is arranged on each springy arm (3, 4, 21, 25) of the at least one springy arm (3, 4, 21, 25) and wherein the at least one protruding part (7, 8, 22, 26) arranged on the respective springy arm is arranged at the second end (6) of the respective springy arm (3, 4, 21, 25), wherein the second casing part (2) comprises
• at least one access channel (13, 18, 19), with each access channel (13, 18, 19) of the at least one access channel having a corresponding protruding part (7, 8, 22, 26) of the at least one protruding part and being configured for receiving the corresponding protruding part (7, 8, 22, 26), with the at least one access channel (13, 18, 19) being arranged such that during the assembly, the at least one corresponding protruding part (7, 8, 22, 26) of the first casing part (1) passes through the at least one access channel (13, 18, 19), and
• at least one mating portion (14), with each mating portion of the at least one mating portion (14) having a corresponding recess (9) of the at least one recess, and with the at least one mating portion (14) being configured to provide, together with the at least one corresponding recess (9) of the first casing part (1), the snap-fit connection after the assembly,
wherein the first casing part (1) and the second casing part (2) are configured such that after the assembly, the first casing part (1) is in a deformed state, and wherein the first casing part (1) and the second casing part (2) are configured such that after the assembly, the first casing part (1) is exerting a force on the at least one mating portion (14) of the second casing part (2).

2. Casing assembly according to claim 1, wherein the exerted force is an elastic restoration force.

3. Casing assembly according to any one of the preceding claims, wherein each of the at least one recess (9) is embodied as a cut-out (9), and wherein each of the at least one mating portion (14) is embodied as a bulging-out obstruction (14), and wherein the first casing part (1) and the second casing part (2) are such that after the assembly, each bulging-out obstruction (14) is arranged in the corresponding cut-out (9).

4. Casing assembly according to any one of the preceding claims, wherein the first casing part (1) and the second casing part (2) are configured such that a shape of the at least one protruding part (7, 8, 22, 26) is substantially the same in both the undeformed state and in the deformed state of the first casing part (1).

5. Casing assembly according to any one of the preceding claims, wherein the first casing part (1) is embodied in one piece and/or wherein the second casing part (2) is embodied in one piece.

6. Casing assembly according to any one of the preceding claims, wherein the first casing part (1) and/or the second casing part (2) are made of a metal, in particular aluminium or steel.

7. Casing assembly according to claim 6, wherein the first casing part (1) is made of a metal sheet and/or wherein the second casing part (2) is made of a metal sheet.

8. Casing assembly according to claim 7, wherein the metal sheet which the first casing part (1) is made of has a thickness between 0.2 mm and 3 mm, in particular between 0.4 mm and 1.2 mm, preferentially equal to 0.8 mm, and/or wherein the metal sheet which the second casing part (2) is made of has a thickness of between 0.5 mm and 5 mm, in particular between 1 mm and 3 mm, preferentially equal to 1.5 mm.

9. Casing assembly according to claim 7 or 8, wherein in the undeformed state, the at least one springy arm (3, 4, 21, 25) is curved, and wherein after the assembly in the deformed state, the at least one springy arm (3, 4, 21, 25) is substantially planar.

10. Casing assembly according to any one of the preceding claims, wherein in both the undeformed state before the assembly and in the deformed state after the assembly, each of the at least one protruding part (7, 8, 22, 26) is oriented in a substantially orthogonal manner to the second end (6) of the respective springy arm (3, 4, 21, 25) on which it is arranged.

11. Casing assembly according to any one of the preceding claims, wherein the second casing part (2) comprises at least one disassembly cut-out (15), with the at least one disassembly cut-out (15) being positioned such that each protruding part of the at least one protruding part (7, 8, 22, 26) that is snap-fitted with a corresponding mating portion (14) after the assembly is accessible from an outside and may be pushed away from the at least one disassembly cut-out (15), and with each disassembly cut-out (15) in particular having a corresponding mating portion (14) of the at least one mating portion and being positioned in a vicinity of the corresponding mating portion (14).

12. Casing assembly according to any one of the preceding claims, wherein the first casing part (1) and the second casing part (2) are such that after the assembly, each protruding part (7, 8, 22, 26) corresponding to an access channel (13, 18, 19) is on at least two opposite sides (18, 19) at least partially and in particular tightly in contact with the second casing part (2).

13. Casing assembly according to any one of the preceding claims, wherein the first casing part (1) comprises at least one bearing surface (21), which at least one bearing surface (21) is positioned such that after the assembly, the second casing part (2) is in contact with the at least one bearing surface (21).

14. Casing assembly according to any one of the preceding claims, wherein the first casing part (1) comprises one springy arm (21), with the at least one protruding part (22) being arranged at the second end (6) of the springy arm (21), wherein the first casing part (1) comprises a first part (23) of a fastening portion arranged at the first end (5) of the springy arm (21), wherein the second casing part (2) comprises a second part (24) of the fastening portion, and wherein the first part (23) and the second part (24) of the fastening portion are configured to fasten the first end (5) of the springy arm (21) to the second casing part (2) after the assembly.

15. Casing assembly according to claim 14, wherein the assembled casing fully surrounds an interior space, and wherein the assembled casing substantially corresponds to a rectangular cuboid, and wherein after the assembly, one surface of the rectangular cuboid is provided by the first casing part (1) and five connected surfaces of the rectangular cuboid are provided by the second casing part (2).

16. Casing assembly according to any one of claims 1 to 10, wherein the first casing part (1) comprises one springy arm (25) and an extension portion (27) connected to the first end (5) of the springy arm (25), with the at least one protruding part (26) being arranged at the second end (6) of the springy arm (25), wherein the first casing part (1) comprises a first part (23) of a fastening portion arranged at a distal end of the extension portion (27) with respect to the first end (5) of the springy arm (25), wherein the second casing part (2) comprises a second part (24) of the fastening portion, wherein the first part (23) and the second part (24) of the fastening portion are configured to fasten the distal end of the extension portion (27) to the second casing part (2) after the assembly, and wherein after the assembly, the assembled casing fully surrounds an interior space and the assembled casing substantially corresponds to a rectangular cuboid, with four connected surfaces of the rectangular cuboid being provided by the second casing part (2) and two connected surfaces of the rectangular cuboid being provided by the springy arm (25) and the extension portion (27).

17. Casing assembly according to any one of claims 1 to 10, wherein
• the first casing part (1) comprises two springy arms (3, 4) and at least two protruding parts (7, 8), with the at least two protruding parts (7, 8) comprising at least two recesses (9), wherein at least one first protruding part (7) of the at least two protruding parts (7, 8) is arranged at the second end (6) of a first springy arm (3) of the two springy arms (3, 4) and wherein at least one second protruding part (8) of the at least two protruding parts (7, 8) is arranged at the second end (6) of a second springy arm (4) of the two springy arms (3, 4), with the at least one first protruding part (7) comprising at least one first recess (9) of the at least two recesses and with the at least one second protruding part (8) comprising at least one second recess (9) of the at least two recesses, and wherein the first casing part (1) comprises a connecting section (11) connecting the two springy arms (3, 4) between their respective first ends (5), and wherein
• the second casing part (2) comprises at least two access channels (13, 18, 19) and at least two mating portions (14), with each access channel (13, 18, 19) of the at least two access channels having a corresponding protruding part (7, 8) of the at least two protruding parts and being configured for receiving the corresponding protruding part (7, 8), with the at least two access channels (13, 18, 19) being arranged such that during the assembly, the corresponding protruding parts (7, 8) of the first casing part (1) pass through the at least two access channels (13, 18, 19), and with each mating portion of the at least two mating portions (14) having a corresponding recess (9) of the at least two recesses, and with the at least two mating portions (14) being configured to provide, together with the corresponding recesses (9) of the first casing part (1), the snap-fit connection after the assembly,
wherein in the undeformed state of the first casing part (1), the two second ends (6) are separated from one another by an undeformed distance (12), and wherein in the deformed state of the first casing part (1), the two second ends (6) are separated from one another by a deformed distance, which deformed distance is smaller than the undeformed distance (12), and wherein the first casing part (1) and the second casing part (2) are configured such that after the assembly, the first casing part (1) is exerting a force on the at least two mating portions (14) of the second casing part (2).

18. Casing assembly according to claim 17, wherein the assembled casing fully surrounds an interior space, wherein the assembled casing substantially corresponds to a rectangular cuboid, and wherein after the assembly, three connected surfaces of the rectangular cuboid are provided by the first casing part (1) and three connected surfaces of the rectangular cuboid are provided by the second casing part (2).

19. Casing assembly according to claims 17 or 18, wherein the first casing part (1) and the second casing part (2) are configured such that the first casing part (1) is symmetric with respect to a first plane of symmetry both in the undeformed state and in the deformed state, which first plane of symmetry intersects the first casing part (1) only in the connecting section (11), wherein the second casing part (2) is symmetric with respect to a second plane of symmetry, which second plane of symmetry is such that after the assembly, the first plane of symmetry and the second plane of symmetry coincide, and wherein the force exerted by the first casing part (1) on the second casing part (2) after the assembly is substantially orthogonal to the coinciding first and second planes of symmetry.

20. Casing assembly according to any one of claims 17 to 19, wherein the first casing part (1) comprises exactly two protruding parts (7, 8), with the at least one first protruding part (7) comprising one protruding part of the exactly two protruding parts and with the at least one second protruding part (8) comprising another protruding part of the exactly two protruding parts, wherein the at least one first recess (9) comprises exactly one first recess (9) and wherein the least one second recess (9) comprises exactly one second recess (9), and wherein the second casing part (2) comprises exactly two access channels (13, 18, 19) and exactly two mating portions (14).

21. Casing assembly according to claim 20, wherein the first casing part (1) and the second casing part (2) are configured such that during the assembly, the two engagement portions (10) pass first through the two access channels (13, 18, 19) before coming into contact with the mating portions (14).
